(19) Europäisches Patentamt
European Patent Office
Office européen des brevets

(11) EP 1 595 919 B1

(12) **EUROPEAN PATENT SPECIFICATION**

(45) Date of publication and mention of the grant of the patent:
**22.08.2012 Bulletin 2012/34**

(51) Int Cl.:
***C08L 63/00*** *(2006.01)* ***C08K 9/06*** *(2006.01)*
***H01L 23/29*** *(2006.01)*

(21) Application number: **05010518.8**

(22) Date of filing: **13.05.2005**

(54) **Epoxy resin composition for semiconductor encapsulation and semiconductor device using the same**

Epoxyharzzusammensetzung zur Einkapselung von Halbleitern und damit eingekapselte Halbleiterbauteile

Composition à base de résine époxy pour l'encapsulage de semi-conducteurs et dispositifs semi-conducteurs encapsulés avec cette composition

(84) Designated Contracting States:
**DE FR IT NL**

(30) Priority: **13.05.2004 JP 2004143861**
**13.05.2004 JP 2004143862**

(43) Date of publication of application:
**16.11.2005 Bulletin 2005/46**

(73) Proprietor: **NITTO DENKO CORPORATION**
**Osaka (JP)**

(72) Inventors:
- **Akizuki, Shinya**
**Ibaraki-shi,**
**Osaka (JP)**
- **Toyota, Kei**
**Ibaraki-shi,**
**Osaka (JP)**
- **Ikemura, Kazuhiro**
**Ibaraki-shi,**
**Osaka (JP)**
- **Ishizaka, Tsuyoshi**
**Ibaraki-shi,**
**Osaka (JP)**
- **Nishioka, Tsutomu**
**Ibaraki-shi,**
**Osaka (JP)**

(74) Representative: **Grünecker, Kinkeldey,**
**Stockmair & Schwanhäusser**
**Leopoldstrasse 4**
**80802 München (DE)**

(56) References cited:
**EP-A- 0 285 450 US-A- 5 609 675**

- **DATABASE CHEMABS CHEMICAL ABSTRACTS SERVICE, COLUMBUS, OHIO, US; 1992, HAYASHI, TAKAO ; FUJITA, NAOKATSU: "Surface treatment of inorganic powder" XP002339178 & JP 04 078433 A (MATSUSHITA ELECTRIC WORKS LTD) 12 March 1992 (1992-03-12)**
- **PATENT ABSTRACTS OF JAPAN vol. 1997, no. 03, 31 March 1997 (1997-03-31) & JP 08 311310 A (MATSUSHITA ELECTRIC WORKS LTD), 26 November 1996 (1996-11-26)**
- **DATABASE WPI Section Ch, Week 200118 Derwent Publications Ltd., London, GB; Class A21, AN 2001-171957 XP002339236 & JP 2000 281878 A (SUMITOMO BAKELITE CO LTD) 10 October 2000 (2000-10-10)**
- **PATENT ABSTRACTS OF JAPAN vol. 2003, no. 12, 5 December 2003 (2003-12-05) & JP 2005 068258 A (DENKI KAGAKU KOGYO KK), 17 March 2005 (2005-03-17)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

This invention relates to an epoxy resin composition for semiconductor encapsulation having excellent formability and excess moisture resistance reliability, in a one-side encapsulation-type package generally called ball grid array (BGA) package and in a type of package called flip chip package, and a semiconductor device using the same.

Semiconductor elements such as transistor, IC, LSI and the like are made into semiconductor devices by encapsulation with a plastic package or the like, from the viewpoint of protecting external environment and from the viewpoint of enabling easy handling of semiconductor elements. Recently, great concern has been directed toward the thinning of a one-side encapsulation-type package such as the BGA package and the stacking in which two or more semiconductor elements are piled and packaged, as the demands accompanied by the thinning of semiconductor devices and high density mounting.

As an encapsulating material which has excellent fluidity and the like and is used in such a BGA package, it has been proposed, for example, to use an encapsulating material prepared by formulating a compound represented by the following general formula (A) (cf. Reference 1).

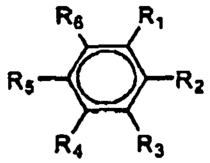

... (A)

In the formula (A), $R_1$ to $R_6$ may be the same or different from one another, and each represents hydrogen atom, an alkyl group having from 1 to 12 carbon atoms or 2,3-epoxypropoxy group, with the proviso that at least two of them are 2,3-epoxypropoxy group.

In addition, recently, a method in which a semiconductor element is mounted on a wiring circuit-formed substrate by a face-down structure (flip chip system) is drawing attention as a demand accompanied by the improvement of performance of semiconductor devices. For the resin encapsulation of a package having such a structure, a system in which a liquid resin composition is used as the encapsulating material, and the gap between the semiconductor element and substrate is encapsulated by filling this by osmotic pressure, has been employed, but in view of mass productivity and reliability, an encapsulating method by a transfer molding system has been examined.

As the encapsulating material which is used when such a flip chip package is prepared by transfer molding, for example, it has been proposed to use an encapsulating material in which particle diameter of silica powder is adjusted to 24 $\mu$m or less (cf. Reference 2).
Reference 1: JP-A-8-111468
Reference 2: JP-A-2000-281878

JP-A-4078433 relates to a surface treatment method for inorganic powder, wherein the surface modification is performed by treating the inorganic filler with a silane coupling agent comprising a reactive group together with a surfactant.

JP-A-08311310 discloses an epoxy resin composition for sealing comprising an epoxy resin, a hardener and silica powder subjected to a surface treatment as constitutional materials. The surface treatment of the silica powder is carried out by reacting the filler with a silane coupling agent which comprises reactive groups.

EP-A-0285450 discloses an epoxy resin composition useful for sealing a semiconductor device including an epoxy resin, a phenolic resin and surface treated silica powder. The silica powder is treated with a silane coupling agent having a reactive group, such as vinyl group, an epoxy group, a mercapto group, an amino group, or a methacryloxy group.

However, the aforementioned stacked one-side encapsulation-type package has a problem of generating entangled voids due to a disorder of balance of the drift velocity of the encapsulating material on each semiconductor element and the drift velocity of the encapsulating material between the semiconductor elements.

In addition, when a flip chip package is encapsulated by transfer molding using the aforementioned encapsulating material, it causes problems in that (1) an unfilled moiety is formed in the gap between the semiconductor element and the substrate, and a void is generated caused by this, (2) surface peeling between the semiconductor element and encapsulating resin part and surface peeling between the former and the solder resist moiety are generated in the excess moisture resistance reliability evaluation after molding, and (3) warping of the flip chip package is generated.

It was the object to provide an epoxy resin composition for semiconductor encapsulation having excellent filling property and anti-entangled void property, and a semiconductor device which uses the same.

Said object is achieved by the epoxy resin composition of claim 1.

The present inventors have conducted a series of studies with the aim of obtaining an epoxy resin composition

which has excellent anti-entangled void property and is used for encapsulating a one-side encapsulation-type package. As a result, it was that when an inorganic filler containing a specified amount of a minute spherical inorganic filler prepared by surface-treating it using a specified silane coupling agent is used, fluidity balance of the encapsulating material is improved and generation of entangled voids is inhibited, because it is considered that resistance of the inorganic filler to resin components is reduced. In addition, the present inventors have conducted a series of studies with the aim of obtaining an epoxy resin composition capable of becoming an encapsulating material which can add filling property as an essential condition and is also excellent in excess moisture resistance reliability. As a result, when a specified epoxy resin (component (A)) is used and a spherical inorganic filler having a specified particle diameter prepared by surface-treating it using a specified silane coupling agent is further used, it was considered that surface resistance of the resin components to the inorganic filler is reduced and it particularly exerts viscosity reducing action within narrow gaps, so that it was found that, for example, filling property of the gap between a semiconductor element and a substrate in a flip chip package is improved, generation of voids is inhibited, excess moisture resistance reliability also becomes superior, and improvement of warp characteristics is realized. By further conducting intensive studies based on these findings, the invention was accomplished.

The present invention include the following embodiments.

1. An epoxy resin composition for semiconductor encapsulation, which comprises the following component (A), component (B), component (C) and component (D):

    (A) an epoxy resin,
    (B) a phenol resin,
    (C) a curing accelerator, and
    (D) a spherical inorganic filler having been surface-treated with a silane coupling agent having acrylate group or methacrylate group,

    wherein the component (D) spherical inorganic filler has a containing ratio of 0.3% by weight or less for the one having a particle diameter of 45 μm or more and has an average particle diameter of 15 μm or less.
    Preferred embodiments are set forth in the subclaims.

Thus, the invention is an epoxy resin composition for semiconductor encapsulation, which contains an inorganic filler containing a spherical inorganic filler prepared by surface-treating it using a specified silane coupling agent, so that excellent filling property and anti-entangled void property can be obtained. Particularly, according to an embodiment of the epoxy resin composition for semiconductor encapsulation, which comprises an inorganic filler containing a specified amount of the aforementioned minute spherical inorganic filler prepared by surface-treating it using a specified silane coupling agent, encapsulation can be suitably carried out without breaking balance of drift velocity in carrying out the encapsulation, so that generation of entangled voids is inhibited, semiconductors having high reliability can be obtained, and particularly, regarding a one-side encapsulation-type package so-called EGA package, those which have high reliability can be obtained. In addition, according to another embodiment of the epoxy resin composition for semiconductor encapsulation, which comprises the aforementioned specified epoxy resin represented by the general formula (1) and the aforementioned spherical inorganic filler having a specified particle diameter prepared by surface-treating it using a specified silane coupling agent, particularly in the case of a package of a flip chip mounting system, it shows excellent filling property for the gap between the semiconductor element and substrate, generation of warping is inhibited, and what is more, generation of surface peeling between semiconductor element and encapsulation part is also inhibited, so that those which have excellent excess moisture resistance reliability can be obtained. This embodiment is useful particularly in producing a type of package called flip chip package through encapsulation by transfer molding, so that a semiconductor device having high reliability can be obtained.

Brief Description of the Drawings

By way of example and to make the description more clear, reference is made to the accompanying drawing in which:

Fig. 1A is a top plan view showing a sample of a semiconductor element mounted substrate which is used in evaluating anti-entangled void property, and Fig. 1B is its side elevation view.
Fig. 2 is a top plan view showing a condition of voids generated by encapsulating the aforementioned sample.
Fig. 3A is a top plan view showing a sample of a semiconductor element mounted substrate which is used in evaluating filling property and generation of surface peeling, and Fig. 3B is its side elevation view.

Fig. 4 is a top plan view showing a condition of voids generated by encapsulating the aforementioned sample.

Detailed Description of the Invention

The epoxy resin composition for semiconductor encapsulation of the invention is obtained using an epoxy resin (component A), a phenol resin (component B), a curing accelerator (component C) and a specified inorganic filler (component D), and is generally in the form of powder or in the form of tablet prepared by making the former into a tablet.

The aforementioned epoxy resin (component A) is not particularly limited, and a conventionally known epoxy resin is used. For example, a dicyclopentadiene type epoxy resin, a cresol novolak type epoxy resin, a phenol novolak type epoxy resin, a bisphenol type epoxy resin, a biphenyl type epoxy resin, a trishydroxyphenylmethane type epoxy resin and the like various epoxy resins can be used. These may be used alone or as a combination of two or more. Among these epoxy resins, it is particularly desirable that the melting point or softening point exceeds room temperature. For example, as the cresol novolak type epoxy resin, those which have an epoxy equivalent of from 180 to 210 and a softening point of from 60 to 110°C are suitably used. Also, as the aforementioned bifunctional type epoxy rein, those which have an epoxy equivalent of from 180 to 210 and a softening point of from 80 to 120°C are suitably used. However, it is desirable that the aforementioned bifunctional type epoxy rein occupies at least 30% by weight of the entire epoxy resin components. Illustratively, the epoxy resins represented by the following structural formula (1) and structural formula (2) are suitably used.

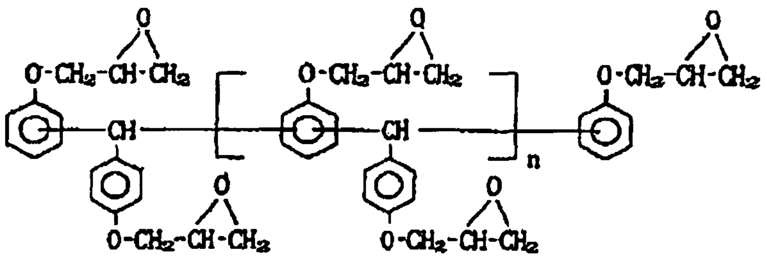

··· (1)

In the formula (1), n is 0 or a positive number.

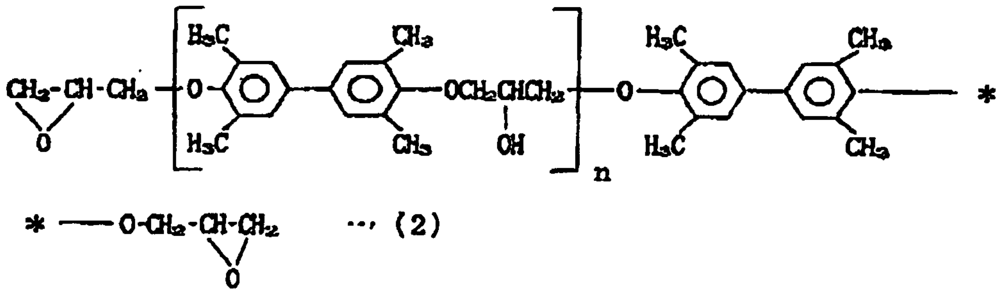

···, (2)

In the formula (2), n is 0 or a positive number.

As the epoxy resin (component A), the one represented by the aforementioned general formula (1) is particularly desirable.

In the aforementioned formula (1), the repeating number n is preferably within a range of from 1 to 5. In addition, it is desirable that the epoxy equivalent is within a range of from 160 to 180, and the softening point is within a range of from 60 to 80°C.

In this connection, when other epoxy resin is jointly used together with the aforementioned epoxy resin represented by the general formula (1), it is desirable to set the aforementioned epoxy resin represented by the general formula (1) to such a ratio that it becomes 70% by weight or more of the entire epoxy resin components.

The phenol resin (component B) which is used together with the aforementioned epoxy resin (component A) exerts a function as a curing agent of the aforementioned epoxy resin and is not particularly limited, and conventionally known various phenol resins are used. For example, an aralkyl type, a dicyclopentadiene type, a cresol novolak type, a phenol novolak type, a bisphenol type, a trishydroxyphenylmethane type and the like various phenol resins can be

used, and these may be used alone or as a combination of two or more. In addition, as these phenol resins, it is desirable to use those which have a hydroxyl group equivalent of from 70 to 250 and a softening point of from 50 to 110°C. Among the aforementioned phenol resins, it is desirable to use a phenol rein which comprises an aralkyl type at a ratio of at least 70% by weight of the entire types. Illustratively, the phenol resins represented by the following structural formula (3) and structural formula (4) are suitably used.

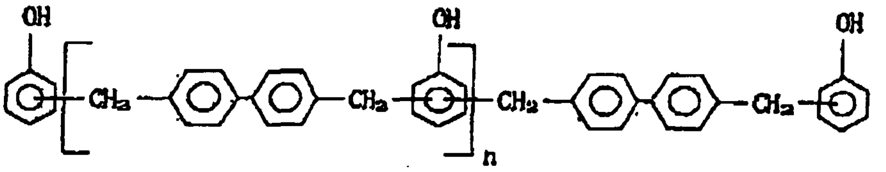 ··· (3)

In the formula (3), n is 0 or a positive number.

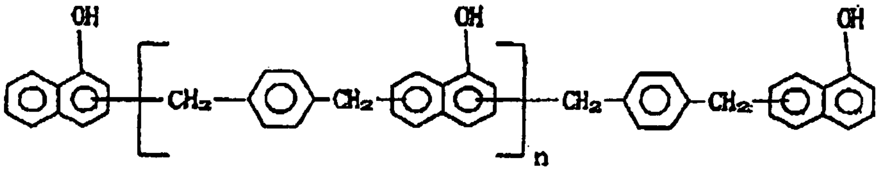 ··· (4)

In the formula (4), n is 0 or a positive number.

Regarding blending ratio of the aforementioned epoxy resin (component A) and phenol resin (component B), it is desirable to blend them in such amounts that hydroxyl group equivalent in the phenol resin becomes from 0.7 to 1.5 equivalents based on 1 epoxy group equivalent in the epoxy resin. More preferred is from 0.9 to 1.2 equivalents.

The curing accelerator (component C) which is used together with the aforementioned component A and component B is not particularly limited, and conventionally known various curing accelerators can be exemplified, such as tetraphenylphosphonium tetraphenyl borate, triphenylphosphine and the like organic phosphorus system compounds, 1,8-diazabicyclo (5,4,0) undecene-7,1,5-diazabicyclo (4,3,0) nonene-5 and the like diazabicycloalkene type compounds. These may be used alone or as a combination of two or more.

It is desirable to set containing amount of the aforementioned curing accelerator (component C) to within a range of from 1 to 20 parts by weight (to be referred to as "part (s)" hereinafter), more preferably from 2 to 15 parts, based on 100 parts of the aforementioned phenol resin (component B). That is, this is because the intended curing reaction of the epoxy resin (component A) with phenol resin (component B) hardly progresses when the content is less than 1 part so that it becomes difficult to obtain sufficient curing property, and when it exceeds 20 parts, the curing reaction becomes so quick that it causes a tendency of spoiling moldabillty.

The specified inorganic filler (component D) to be used together with the aforementioned components A to C is a spherical inorganic filler prepared by surface-treating it with a specified silane coupling agent.

The specified silane coupling agent to be used in the aforementioned surface treatment has an acrylate group or methacrylate group, and it is considered that resistance of the inorganic filler to the organic components is reduced by having such an organic group. Illustrative examples of the aforementioned specified silane coupling agent include respective silane coupling agents represented by the following structural formula (5), structural formula (6), structural formula (7), structural formula (8) and structural formula (9). Particularly, from the viewpoint of most effectively inhibiting entangled voids, it is desirable to use the silane coupling agent represented by the following structural formula (9).

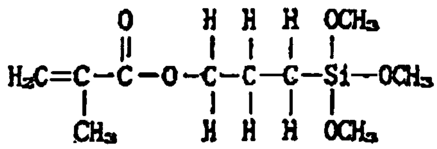 ··· (5)

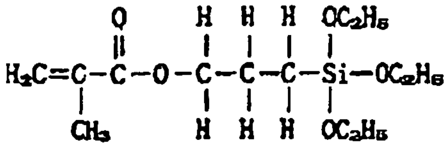

··· (6)

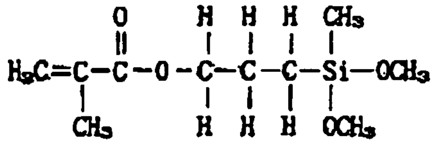

··· (7)

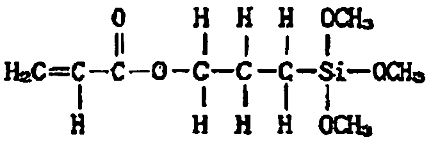

··· (8)

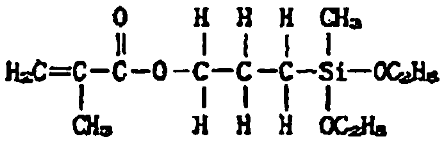

··· (9)

Regarding the aforementioned spherical inorganic filler to be surface-treated, for example, quarts glass powder, talc, silica powder (molten silica powder, crystalline silica powder or the like), alumina powder, aluminum nitride, silicon nitride powder and the like can be cited. These may be used alone or as a combination of two or more. Among them, from the viewpoint that coefficient of linear expansion of the obtained cured product can be reduced, it is desirable to use the aforementioned silica powder, and as the aforementioned silica powder, it is particularly desirable to use molten silica powder (preferably spherical molten silica powder) in view of high filling property and high fluidity.

Regarding its particle diameter distribution, it is desirable that the containing ratio of a filler having a particle diameter of 45 μm or more is 0.3% by weight or less of the entire filler, and the average particle diameter of the entire filler is 15 μm or less. Particularly preferably, the containing ratio of a filler having a particle diameter of 45 μm or more is 0.2% by weight or less of the entire filler, and its average particle diameter is 11 μm or less. In this connection, lower limit of the aforementioned containing ratio of a filler having a particle diameter of 45 μm or more is 0% by weight, and lower limit of the aforementioned average particle diameter is 3 μm. That is, this is because narrow gap filling property of the flip chip part becomes worsen in some cases when the containing ratio of a filler having a particle diameter of 45 μm or more exceeds 0.3% by weight. Also, this is because narrow gap filling property of the flip chip part sometimes becomes worsen in the same manner when the average particle diameter becomes large exceeding 15 μm.

In this connection, the containing ratio of a filler having a particle diameter of 45 μm or more can be measured, for example, by screening it using a screen (mesh), and the average particle diameter can be measured, for example, using a laser diffraction scattering type particle size distribution analyzer. In addition, the aforementioned residue on sieve and average particle diameter are values obtained from samples optionally extracted from the population using the aforementioned screen and analyzer.

According to the invention, the aforementioned spherical inorganic filler prepared by surface-treating it using a specified silane coupling agent can also be used in combination with other inorganic filler. In that case, it is desirable to contain a spherical inorganic filler having an average particle diameter of from 0.5 to 3 μm within a range of from 5 to 50% by weight of the entire inorganic filler (component D), particularly preferably from 5 to 20% by weight of the entire inorganic filler (component D). That is, this is because when it is less than 5% by weight, the viscosity increases in some cases due to too small containing amount of the surface-treated spherical inorganic filler, and when it exceeds 50% by weight, it sometimes accompanies increase in the viscosity at the time of low flow rate due to increase in the specific

surface area of silica.

Regarding the aforementioned spherical inorganic filler to be surface-treated, it is desirable to use spherical molten silica powder. Its average particle diameter is within a range of preferably from 0.5 to 3 μm, particularly preferably from 0.6 to 2.9 μm. That is, this is because when it is too small such as less than 0.5 μm, it sometimes accompanies increase in the viscosity at the time of low flow rate due to increase in the specific surface area of silica. This is also because when it is large exceeding 3 μm, it accompanies increase of the viscosity in some cases.

The inorganic filler which contains a certain amount of the spherical inorganic filler having an average particle diameter of from 0.5 to 3 pm prepared by surface-treating with the aforementioned specified silane coupling agent is not particularly limited, and various conventionally known fillers can be used. For example, quarts glass powder, talc, silica powder, alumina powder, aluminum nitride, silicon nitride powder and the like can be cited. These inorganic fillers can be used in any of pulverized, spherical and ground forms. Among them, it is desirable to use molten silica powder in view of high filling and high fluidity. As the aforementioned molten silica powder, spherical molten silica powder and pulverized molten silica powder can be exemplified, and it is particularly desirable to use spherical molten silica powder from the viewpoint of fluidity. In addition, its average particle diameter is within the range of preferably from 5 to 30 μm, particularly preferably from 10 to 20 μm. In this connection, according to the invention, the average particle diameter can be measured, for example, using a laser diffraction scattering type particle size distribution analyzer.

The aforementioned method for surface-treating the surface of the specified spherical inorganic filler using a silane coupling agent is not particularly limited, and its examples include a wet treatment in which the spherical inorganic filler and silane coupling agent are mixed in a solvent and a dry treatment in which the spherical inorganic filler and silane coupling agent are subjected to the treatment in a gas phase.

In addition, it is desirable to set containing amount of the aforementioned inorganic filler (component D) to a range of from 50 to 95% by weight, particularly preferably from 70 to 90% by weight, based on the entire epoxy resin composition. This is because when it is less than 50% by weight, moisture absorption of the encapsulating resin increases and the resin strength is reduced in some cases, thus showing a tendency of easily generating cracks and pealing at the time of reflow of the semiconductor package.

In this connection, in addition to the aforementioned components A to D, the epoxy resin composition of the invention for semiconductor encapsulation can be optionally blended with other additive agent as occasion demands, such as a flame retarder, a flame retarder assistant, a mold releasing agent, carbon black and the like pigments and colorants, γ-glycidoxypropyltrimethoxysilane, γ-mercaptopropyltrimethoxysilane, γ-aminoethylaminopropyltrimethoxysilane and the like silane coupling agents, a stress reducing agent and the like.

As the aforementioned flame retarder, a novolak type brominated epoxy resin or the like halogen system flame retarder can be cited, and diantimony trioxide, diantimony pentoxide or the like is used as the aforementioned flame retarder assistant. These may be used alone or as a combination of two or more.

As the aforementioned mold releasing agent, a higher fatty acid, a higher fatty acid ester, a higher fatty acid calcium and the like compounds can be exemplified. For example, carnauba wax, a polyethylene system wax and the like can be cited, and these may be used alone or as a combination of two or more.

In addition, as the aforementioned stress reducing agent, acrylonitrile-butadiene rubber and the like can be exemplified.

The epoxy resin composition for semiconductor encapsulation of the invention can be produced, for example, in the following manner. That is, the aforementioned components A to D and, as occasion demands, other additive agents are optionally mixed in accordance with a general method and then applied to a mixing roller or the like kneader to melt-knead the mixture under a heated condition, and this is solidified by cooling to room temperature. Thereafter, the composition can be produced by a series of steps of pulverizing it by a conventionally known means and making the resulting powder into tablets.

The method for encapsulating a semiconductor element using such an epoxy resin composition is not particularly limited, and it can be carried out by a usual transfer molding or the like conventionally known molding method, and the product can be made into a semiconductor device.

In addition, as a semiconductor device as an object to be encapsulated using such an epoxy resin composition, for example, a flip chip package prepared by mounting a semiconductor element on a wiring circuit-formed substrate by a face-down structure can be cited, in which the gap between the aforementioned semiconductor element and substrate is filled and encapsulated with the epoxy resin composition.

Next, Examples are describe jointly with Comparative Examples.

Firstly, respective components shown in the following were prepared prior to the Examples.

Epoxy resin a:

An epoxy resin represented by the following structural formula (a) (epoxy equivalent 170, softening point 69°C)

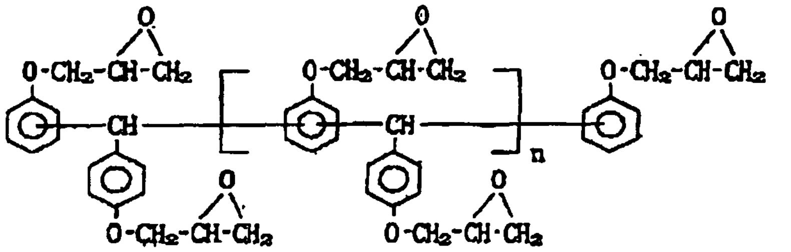

··· (a)

Epoxy resin b:

An epoxy resin represented by the following structural formula (b) (epoxy equivalent 177, melting point 141°C)

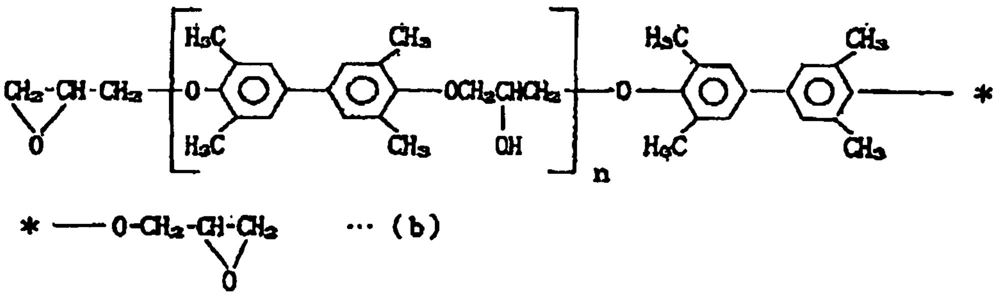

··· (b)

Epoxy resin c:

An epoxy resin represented by the following structural formula (c) (epoxy equivalent 195, melting point 107°C)

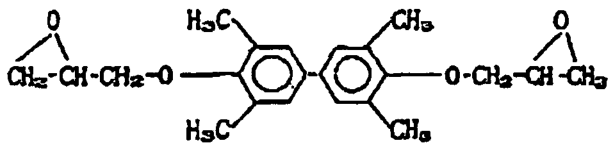

··· (c)

Epoxy resin d:

An epoxy resin represented by the following structural formula (d) (epoxy equivalent 195, melting point 67°C)

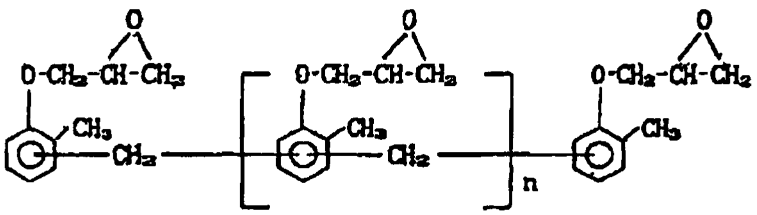

··· (d)

Phenol resin a:

A phenol resin represented by the following structural formula (e) (hydroxyl group equivalent 210, softening point 73°C)

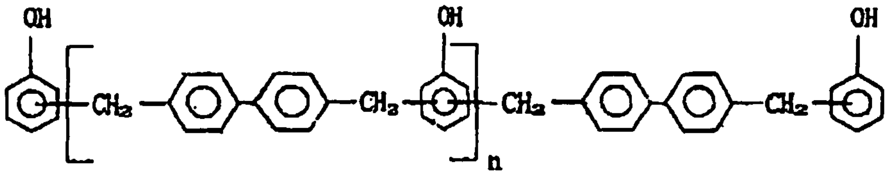

... (e)

Phenol resin b:

A phenol resin represented by the following structural formula (f) (hydroxyl group equivalent 220, softening point 77°C)

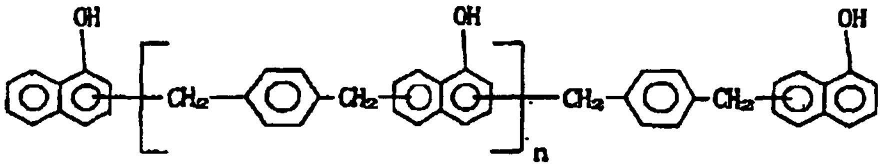

... (f)

Phenol resin c:

A phenol novolak resin (hydroxyl group equivalent 107, softening point 64°C)

Phenol resin d:

A phenol novolak resin (hydroxyl group equivalent 107, softening point 85°C)

Phenol resin e:

A phenol resin represented by the following structural formula (g) (hydroxyl group equivalent 172, softening point 67°C)

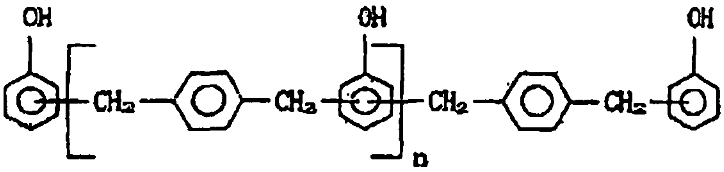

... (g)

Phenol resin f:

A phenol resin represented by the following structural formula (h) (hydroxyl group equivalent 93, softening point 66°C)

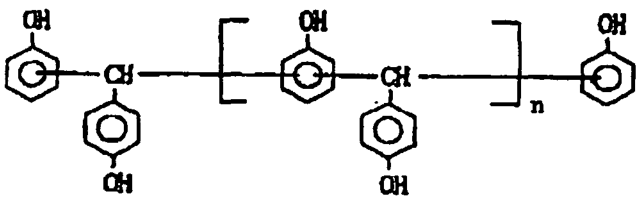

... (h)

Mold releasing agent:

Carnauba wax

Curing accelerator:

Triphenylphosphine

Inorganic filler a1:

One gram of a silane coupling agent represented by the following structural formula (α) (KBE 502, mfd. by Shin-Etsu Chemical) and 10 g of water were diluted with 300 ml of acetone, and this was poured into 100 g of a spherical molten silica powder (average particle diameter 0.7 μm) in a 1 liter capacity beaker to prepare a slurry. Then, this slurry was stirred for about 15 hours using a magnetic stirrer. After the stirring, the aforementioned slurry was transferred into an aluminum pallet spread with aluminum foil, and the solvent was evaporated to dryness at 105°C on a hot plate. After the evaporation to dryness, this was further heated at 95°C for 30 minutes in a dryer, thus preparing the aforementioned inorganic filler a1 in which the spherical molten silica powder surface was treated with a silane coupling agent.

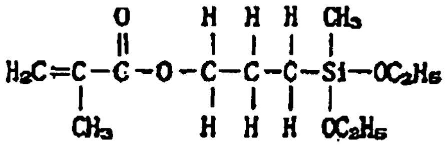

··· (α)

Inorganic filler a2:

A spherical molten silica powder having an average particle diameter of 3 μm was used as the spherical molten silica powder. In the same manner as in the aforementioned inorganic filler a1 except for this, the inorganic filler a2 in which the spherical molten silica powder surface was treated with a silane coupling agent was prepared.

Inorganic filler b1:

The silane coupling agent was changed to a silane coupling agent represented by the following structural formula (β) (KBM 803, mfd. by Shin-Etsu Chemical) . In the same manner as in the aforementioned inorganic filler a1 except for this, the inorganic filler b1 in which the spherical molten silica powder surface was treated with a silane coupling agent was prepared.

$$HS-C_3H_6Si(OCH_3)_3 \quad \cdots \quad (\beta)$$

Inorganic filler b2:

The silane coupling agent was changed to a silane coupling agent represented by the following structural formula (γ) (KBE 903, mfd. by Shin-Etsu Chemical) . In the same manner as in the aforementioned inorganic filler a1 except for this, the inorganic filler b2 in which the spherical molten silica powder surface was treated with a silane coupling agent was prepared.

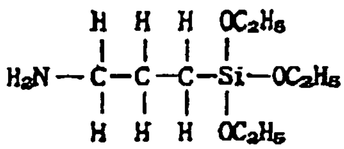

··· (γ)

Inorganic filler o:

A spherical molten silica powder (average particle diameter 13.2 μm)

Inorganic filler d:

A spherical molten silica powder (average particle diameter 16.2 μm)

Inorganic filler a3:

One gram of a silane coupling agent represented by the following structural formula (α) (KBE 502, mfd. by Shin-Etsu Chemical) and 10 g of water were diluted with 300 ml of acetone, and this was poured into 100 g of a spherical molten silica powder (0.17% by weight in residue on sieve having a particle diameter of 45 μm or more, 11 μm in average particle diameter: FB-7SDC, mfd. by DENKI KAGAKU KOGYO) in a 1 liter capacity beaker to prepare a slurry. Then, this slurry was stirred for about 15 hours using a magnetic stirrer. After the stirring, the aforementioned slurry was transferred into an aluminum pallet spread with aluminum foil, and the solvent was evaporated to dryness at 105°C on a hot plate. Subsequently, after the evaporation to dryness, this was further heated at 95°C for 30 minutes in a dryer, thus preparing the aforementioned inorganic filler a3 in which the spherical molten silica powder surface was treated with a silane coupling agent.

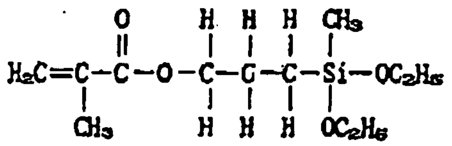

··· (α)

Inorganic filler a4:

A spherical molten silica powder having 0.3% by weight of a residue on sieve of 45 μm or more in particle diameter and 15 μm in average particle diameter (FB-8S, mfd. by DENKI KAGAKU KOGYO) was used as the spherical molten silica powder. In the same manner as in the aforementioned inorganic filler a3 except for this, the inorganic filler a4 in which the spherical molten silica powder surface was treated with a silane coupling agent was prepared.

Inorganic filler b3

A spherical molten silica powder having 0.17% by weight of a residue on sieve of 45 μm or more in particle diameter and 11 μm in average particle diameter.

Inorganic filler b4:

A spherical molten silica powder having 5.0% by weight of a residue on sieve of 45 μm or more in particle diameter and 15 μm in average particle diameter (MSR-FC408, mfd. by Tatsumori) was used as the spherical molten silica powder. In the same manner as in the aforementioned inorganic filler a3 except for this, the inorganic filler b4 in which the spherical molten silica powder surface was treated with a silane coupling agent was prepared.

Inorganic filler b5:

A spherical molten silica powder having 0.5% by weight of a residue on sieve of 45 μm or more in particle diameter and 20 μm in average particle diameter was used as the spherical molten silica powder. In the same manner as in the aforementioned inorganic filler a3 except for this, the inorganic filler b5 in which the spherical molten silica powder surface was treated with a silane coupling agent was prepared.

Inorganic filler b6:

The silane coupling agent was changed to a silane coupling agent represented by the following structural formula (β) (KBM 803, mfd. by Shin-Etsu Chemical) . In the same manner as in the aforementioned inorganic filler a3 except for this, the inorganic filler b6 in which the spherical molten silica powder surface was treated with a silane coupling

agent was prepared.

$$HS-C_3H_6Si(OCH_3)_3 \quad \cdots \quad (\beta)$$

Examples 1 to 16 and Comparative Examples 1 to 9

Respective components shown in the following Table 1 to Table 3 were mixed at the ratio shown in the same tables and melt-kneaded for 3 minutes using a mixing roller (temperature 100°C). Thereafter, this molten product was cooled and then pulverized to obtain respective epoxy resin composition for semiconductor encapsulation of interest. In this connection, "part(s)" represents "part(s) by weight".

Table 1

| | | | | | | | | | (part (s)) |
|---|---|---|---|---|---|---|---|---|---|
| | | Examples | | | | | | | |
| | | 1 | 2 | 3 | 4 | 5 | 6 | 7 | 8 |
| Epoxy resin | a | - | - | - | - | - | - | - | 33 |
| | b | - | - | - | - | - | - | 100 | 64 |
| | c | 100 | 100 | 100 | 100 | 100 | 100 | - | - |
| Phenol resin | a | 108 | 108 | 108 | 108 | 108 | 108 | 119 | - |
| | b | - | - | - | - | - | - | - | 50 |
| | c | - | - | - | - | - | - | - | 35 |
| Mold releasing agent | | 2 | 2 | 2 | 2 | 2 | 2 | 2 | 2 |
| Curing accelerator | | 1 | 1 | 1 | 1 | 1 | 1 | 1 | 1 |
| Inorganic filler | a1 | 80 | 150 | 450 | 750 | 150 | 450 | 150 | 150 |
| | a2 | - | - | - | - | - | - | - | - |
| | b1 | - | - | - | - | - | - | - | - |
| | b2 | - | - | - | - | - | - | - | - |
| | c | 1420 | 1350 | 1050 | 750 | - | - | 1350 | 1350 |
| | d | - | - | - | - | 1350 | 1050 | - | - |
| Amount of inorganic filler in epoxy resin composition (wt %) | | 87.7 | 87.7 | 87.7 | 87.7 | 87.7 | 87.7 | 87.1 | 89.0 |
| Amount of surface-treated inorganic filler in the inorganic filler (wt %) | | 5.3 | 10.0 | 30.0 | 50.0 | 10.0 | 30.0 | 10.0 | 10.0 |

Table 2

| | | | | | | | | | (part (s)) |
|---|---|---|---|---|---|---|---|---|---|
| | | Examples | | | | | | | |
| | | 9 | 10 | 11 | 12 | 13 | 14 | 15 | 16 |
| Epoxy resin | a | - | - | - | - | - | - | - | 33 |
| | b | - | - | - | - | - | - | 100 | 64 |
| | c | 100 | 100 | 100 | 100 | 100 | 100 | - | - |

(continued)

| (part (s)) | | | | | | | | | | |
|---|---|---|---|---|---|---|---|---|---|---|
| | | Examples | | | | | | | |
| | | 9 | 10 | 11 | 12 | 13 | 14 | 15 | 16 |
| Phenol resin | a | 108 | 108 | 108 | 108 | 108 | 108 | 119 | - |
| | b | - | - | - | - | - | - | - | 50 |
| | c | - | - | - | - | - | - | - | 35 |
| Mold releasing agent | | 2 | 2 | 2 | 2 | 2 | 2 | 2 | 2 |
| Curing accelerator | | 1 | 1 | 1 | 1 | 1 | 1 | 1 | 1 |
| Inorganic filler | a1 | - | - | - | - | - | - | - | - |
| | a2 | 80 | 150 | 450 | 750 | 150 | 450 | 150 | 150 |
| | b1 | - | - | - | - | - | - | - | - |
| | b2 | - | - | - | - | - | - | - | - |
| | c | 1420 | 1350 | 1050 | 750 | - | - | 1350 | 1350 |
| | d | - | - | - | - | 1350 | 1050 | - | - |
| Amount of inorganic filler in epoxy resin composition (wt %) | | 87.7 | 87.7 | 87.7 | 87.7 | 87.7 | 87.7 | 87.1 | 89.0 |
| Amount of surface-treated inorganic filler in the inorganic filler (wt %) | | 5.3 | 10.0 | 30.0 | 50.0 | 10.0 | 30.0 | 10.0 | 10.0 |

Table 3

| (part (s)) | | | | | | | | | | |
|---|---|---|---|---|---|---|---|---|---|---|
| | | Comparative Examples | | | | | | | | |
| | | 1 | 2 | 3 | 4 | 5 | 6 | 7 | 8 | 9 |
| Epoxy resin | a | - | - | - | - | - | - | - | - | 33 |
| | b | - | - | - | - | - | - | - | 100 | 64 |
| | c | 100 | 100 | 100 | 100 | 100 | 100 | 100 | - | - |
| Phenol resin | a | 108 | 108 | 108 | 108 | 108 | 108 | 108 | 119 | - |
| | b | - | - | - | - | - | - | - | - | 50 |
| | c | - | - | - | - | - | - | - | - | 35 |
| Mold releasing agent | | 2 | 2 | 2 | 2 | 2 | 2 | 2 | 2 | 2 |
| Curing accelerator | | 1 | 1 | 1 | 1 | 1 | 1 | 1 | 1 | 1 |
| Inorganic filler | a1 | 20 | 1000 | 1200 | - | - | 800 | - | 1000 | 1000 |
| | a2 | - | - | - | - | - | - | 1000 | - | - |
| | b1 | - | - | - | 150 | - | - | - | - | - |
| | b2 | - | - | - | - | 150 | - | - | - | - |
| | c | 1480 | 500 | 300 | 1350 | 1350 | 700 | 500 | 500 | 500 |
| | d | - | - | - | - | - | - | - | - | - |
| Amount of inorganic filler in epoxy resin composition (wt %) | | 87.7 | 87.7 | 87.7 | 87.7 | 87.7 | 87.7 | 87.7 | 87.7 | 87.7 |

(continued)

| (part (s)) | | | | | | | | | |
|---|---|---|---|---|---|---|---|---|---|
| | Comparative Examples | | | | | | | | |
| | 1 | 2 | 3 | 4 | 5 | 6 | 7 | 8 | 9 |
| Amount of surface-treated inorganic filler in the inorganic filler (wt %) | 1.3 | 66.7 | 80.0 | 10.0 | 10.0 | 53.3 | 66.7 | 66.7 | 66.7 |

Using the thus obtained epoxy resin compositions of Examples and Comparative Examples, anti-entangled void property, verification of warping and pressure cooker test (PCT test) were measured and evaluated in accordance with the methods described below. These results are shown in the following Table 4 to Table 6.

Anti-entangled, void property:

As shown in Fig. 1A and Fig. 1B, a sample in which 9 chips of a semiconductor element 1 (chip size: 10 mm x 10 mm x 0.5 mm in thickness) were mounted on a substrate 2 (size: 50 mm x 50 mm x 0.3 mm in thickness) was prepared.

Using each of the epoxy resin compositions obtained in the Examples and Comparative Examples, the aforementioned semiconductor element-mounted substrate was subjected to transfer molding (condition: 175°C x 90 seconds) using a die having a cavity size of 50 mm x 50 mm x 0.7 mm in depth, thereby effecting encapsulation by forming an encapsulating resin layer 3 in such a manner that the chips of the semiconductor element 1 on the substrate 2 were included as shown in Fig. 2. The number of packages in which an external void 4 was generated on the semiconductor element 1 as a result was counted. In this connection, since the transfer molding was carried out by preparing two samples in which 9 chips of the semiconductor element 1 were mounted on the substrate 2, the number of prepared packages was 18.

Verification of warping:

Warping quantity of the semiconductor packages prepared in the above was verified in the following manner. That is, length of the maximum warping part from the horizontal surface when each semiconductor package was put on the horizontal surface was measured. An optical microscope was used in the measurement.

PCT test:

Each of the semiconductor packages prepared in the above was put into a PCT chamber and allowed to stand for 196 hours under a condition of 130°C x 85% RH. Using this, the presence or absence of surface peeling was verified by a supersonic detector, and the number of packages which generated surface peeling was counted. In this connection, the number of prepared packages was 18 similar to the above.

Table 4

| | Examples | | | | | | | |
|---|---|---|---|---|---|---|---|---|
| | 1 | 2 | 3 | 4 | 5 | 6 | 7 | 8 |
| Anti-entangled void property (packages/18 packages) | 0/18 | 0/18 | 0/18 | 0/18 | 0/18 | 0/18 | 0/18 | 0/18 |
| Warping ($\mu$m) | 70 | 80 | 70 | 90 | 70 | 80 | 90 | 60 |
| PCT test | 0/18 | 0/18 | 0/18 | 0/18 | 0/18 | 0/18 | 0/18 | 0/18 |

Table 5

| | Examples | | | | | | | |
|---|---|---|---|---|---|---|---|---|
| | 9 | 10 | 11 | 12 | 13 | 14 | 15 | 16 |
| Anti-entangled void property (packages/18 packages) | 0/18 | 0/18 | 0/18 | 0/18 | 0/18 | 0/18 | 0/18 | 0/18 |

(continued)

| | Examples | | | | | | | |
|---|---|---|---|---|---|---|---|---|
| | 9 | 10 | 11 | 12 | 13 | 14 | 15 | 16 |
| Warping ($\mu$m) | 80 | 80 | 70 | 60 | 90 | 70 | 80 | 50 |
| PCT test | 0/18 | 0/18 | 0/18 | 0/18 | 0/18 | 0/18 | 0/18 | 0/18 |

Table 6

| | Comparative Examples | | | | | | | | |
|---|---|---|---|---|---|---|---|---|---|
| | 1 | 2 | 3 | 4 | 5 | 6 | 7 | 8 | 9 |
| Anti-entangled void property (/18 packages) | 2/18 | 5/18 | 8/18 | 7/18 | 5/18 | 4/18 | 3/18 | 5/18 | 8/18 |
| Warping ($\mu$m) | 80 | 90 | 100 | 80 | 70 | 60 | 70 | 80 | 60 |
| PCT test | 0/18 | 0/18 | 0/18 | 0/18 | 0/18 | 0/18 | 0/18 | 0/18 | 0/18 |

Based on the above results, it was confirmed that the products of Examples did not generate voids on the semiconductor element and that a one-side encapsulation-type semiconductor device having high reliability was obtained.

Contrary to this, the product of Comparative Example 1 caused generation of voids on the semiconductor element due to too small amount of the surface-treated minute spherical molten silica. The products of Comparative Examples 2 and 3 caused generation of voids on the semiconductor elements due to too large amount of the surface-treated minute spherical molten silica. Also, since a minute spherical molten silica surface-treated with a silane coupling agent having no acrylate group or methacrylate group was used in each of the products of Comparative Examples 4 and 5, the effect to inhibit generation of voids was not obtained. In addition, the products of Comparative Examples 6 to 9 caused generation of voids on the semiconductor elements due to too large amount of the surface-treated minute spherical molten silica.

Examples 17 to 32 and Comparative Examples 10 to 23

Respective components shown in the following Table 7 to Table 10 were mixed at the ratio shown in the same tables and melt-kneaded for 3 minutes using a mixing roller (temperature 100°C). Thereafter, this molten product was cooled and then pulverized to obtain respective epoxy resin composition for semiconductor encapsulation of interest. In this connection, "part(s)" represents "part(s) by weight".

Table 7

| | | | | | | | | | (part (s)) |
|---|---|---|---|---|---|---|---|---|---|
| | | Examples | | | | | | | |
| | | 17 | 18 | 19 | 20 | 21 | 22 | 23 | 24 |
| Epoxy resin | a | 100 | 100 | 100 | 80 | 70 | 80 | 100 | 100 |
| | d | - | - | - | 20 | 30 | - | - | - |
| | c | - | - | - | - | - | - | - | 20 |
| Phenol resin | d | 63 | - | - | 62 | - | - | 63 | 63 |
| | e | - | 101 | - | - | 97 | - | - | - |
| | f | - | - | 55 | - | - | 63 | - | - |
| Mold releasing agent | | 2 | 2 | 2 | 2 | 2 | 2 | 2 | 2 |
| Curing accelerator | | 1 | 1 | 1 | 1 | 1 | 1 | 1 | 1 |

(continued)

| | | (part (s)) | | | | | | | |
|---|---|---|---|---|---|---|---|---|---|
| | | Examples | | | | | | | |
| | | 17 | 18 | 19 | 20 | 21 | 22 | 23 | 24 |
| Inorganic filler | a3 | 800 | 800 | 800 | 800 | 800 | 800 | 1200 | 500 |
| | a4 | - | - | - | - | - | - | - | - |
| | b3 | - | - | - | - | - | - | - | - |
| | b4 | - | - | - | - | - | - | - | - |
| | b5 | - | - | - | - | - | - | - | - |
| | b6 | - | - | - | - | - | - | - | - |
| Amount of particles having a particle diameter of 45 μm or more in inorganic filler (wt %) | | 0.17 | 0.17 | 0.17 | 0.17 | 0.17 | 0.17 | 0.17 | 0.17 |
| Average particle diameter of inorganic filler (μm) | | 11 | 11 | 11 | 11 | 11 | 11 | 11 | 11 |

Table 8

| | | (part (s)) | | | | | | | |
|---|---|---|---|---|---|---|---|---|---|
| | | Examples | | | | | | | |
| | | 25 | 26 | 27 | 28 | 29 | 30 | 31 | 32 |
| Epoxy resin | a | 100 | 100 | 100 | 80 | 70 | 80 | 100 | 100 |
| | d | - | - | - | 20 | 30 | - | - | - |
| | c | - | - | - | - | - | 20 | - | - |
| Phenol resin | d | 63 | - | - | 62 | - | - | 63 | 63 |
| | e | - | 101 | - | - | 97 | - | - | - |
| | f | - | - | 55 | - | - | 63 | - | - |
| Mold releasing agent | | 2 | 2 | 2 | 2 | 2 | 2 | 2 | 2 |
| Curing accelerator | | 1 | 1 | 1 | 1 | 1 | 1 | 1 | 1 |
| Inorganic filler | a3 | - | - | - | - | - | - | - | - |
| | a4 | 800 | 800 | 800 | 800 | 800 | 800 | 1200 | 500 |
| | b3 | - | - | - | - | - | - | - | - |
| | b4 | - | - | - | - | - | - | - | - |
| | b5 | - | - | - | - | - | - | - | - |
| | b6 | - | - | - | - | - | - | - | - |
| Amount of particles having a particle diameter of 45 μm or more in inorganic filler (wt %) | | 0.3 | 0.3 | 0.3 | 0.3 | 0.3 | 0.3 | 0.3 | 0.3 |
| Average particle diameter of inorganic filler (μm) | | 15 | 15 | 15 | 15 | 15 | 15 | 15 | 15 |

Table 9

| | | (part (s)) | | | | | | | |
|---|---|---|---|---|---|---|---|---|---|
| | | Comparative Examples | | | | | | | |
| | | 10 | 11 | 12 | 13 | 14 | 15 | 16 | 17 |
| Epoxy resin | a | 100 | 100 | 100 | 100 | 100 | 100 | - | - |
| | d | - | - | - | - | - | -- | 100 | - |
| | c | - | - | - | - | - | - | - | 100 |
| Phenol resin | d | 63 | - | - | 63 | - | - | - | - |
| | e | - | 101 | - | - | 101 | - | 55 | 55 |
| | f | - | - | 55 | - | - | 55 | - | - |
| Mold releasing agent | | 2 | 2 | 2 | 2 | 2 | 2 | 2 | 2 |
| Curing accelerator | | 1 | 1 | 1 | 1 | 1 | 1 | 1 | 1 |
| Inorganic filler | a3 | - | - | - | - | - | - | 800 | 800 |
| | a4 | - | - | - | - | - | - | - | - |
| | b3 | 800 | 800 | 800 | - | - | - | - | - |
| | b4 | - | - | - | 800 | 800 | 800 | - | - |
| | b5 | - | - | - | - | - | - | - | - |
| | b6 | - | - | - | - | - | - | - | - |
| Amount of particles having a particle diameter of 45 μm or more in inorganic filler (wt %) | | 0.17 | 0.17 | 0.17 | 3 | 3 | 3 | 0.17 | 0.17 |
| Average particle diameter of inorganic filler (μm) | | 11 | 11 | 11 | 15 | 15 | 15 | 11 | 11 |

Table 10

| | | (part (s)) | | | | | |
|---|---|---|---|---|---|---|---|
| | | Comparative Examples | | | | | |
| | | 18 | 19 | 20 | 21 | 22 | 23 |
| Epoxy resin | a | 100 | 100 | 100 | 100 | 100 | 100 |
| | d | - | - | - | - | - | - |
| | c | - | - | - | - | - | - |
| Phenol resin | d | 63 | - | - | 63 | - | - |
| | e | - | 101 | - | - | 101 | - |
| | f | - | - | 55 | - | - | 55 |
| Mold releasing agent | | 2 | 2 | 2 | 2 | 2 | 2 |
| Curing accelerator | | 1 | 1 | 1 | 1 | 1 | 1 |
| Inorganic filler | a3 | - | - | - | - | - | - |
| | a4 | - | - | - | - | - | - |
| | b3 | - | - | - | - | - | - |
| | b4 | - | - | - | - | - | - |
| | b5 | 800 | 800 | 800 | - | - | - |
| | b6 | - | - | - | 800 | 800 | 800 |

(continued)

| (part (s)) | | | | | | |
|---|---|---|---|---|---|---|
| | Comparative Examples | | | | | |
| | 18 | 19 | 20 | 21 | 22 | 23 |
| Amount of particles having a particle diameter of 45 μm or more in inorganic filler (wt %) | 0.5 | 0.5 | 0.5 | 0.17 | 0.17 | 0.17 |
| Average particle diameter of inorganic filler (μm) | 20 | 20 | 20 | 11 | 11 | 11 |

Using the thus obtained epoxy resin compositions of Examples and Comparative Examples, generation of unfilling, verification of warping and pressure cooker test (PCT test) were measured and evaluated in accordance with the methods described below. These results are shown in the following Table 11 to Table 14.

Filling property and generation of surface peeling:

As shown in Fig. 3A and Fig. 3B, a sample in which 9 chips of a semiconductor element 5 (chip size: 7 mm x 7 mm x 0.3 mm in thickness) having 100 pieces of an eutectic solder bump 6 arranged on the under surface were mounted on a substrate 7 (size: 50 mm x 50 mm x 0.3 mm in thickness) was prepared.

Using each of the epoxy resin compositions obtained in the Examples and Comparative Examples, the aforementioned flip chip-mounted substrate was subjected to transfer molding (condition: 175°C x 90 seconds) using a die having a cavity size of 50 mm x 50 mm x 0.7 mm in depth and then to after hardening at 175°C for 5 hours. In this way, as shown in Fig. 4, the gap between a substrate 7 and the semiconductor element 5 was encapsulated, while effecting encapsulation by forming an encapsulating resin layer 8 in such a manner that the semiconductor element 5 flip chip-mounted on a substrate 7 was included. Thereafter, as shown in Fig. 4, semiconductor packages were prepared by cutting out each semiconductor element 1 unit along the broken line x. This semiconductor package was PBGA (plastic ball grid array, size: 16 mm x 16 mm x 0.7 mm in thickness of encapsulating resin layer 8). As a result, the number of packages in which un-filled parts were found in the gap between the semiconductor element 5 and the substrate 7 was counted. In this connection, verification of the aforementioned un-filled parts was carried out using a supersonic detector, and their presence was confirmed by cutting each package and observing its sections. Also, since the transfer molding was carried out by preparing two samples in which 9 chips of the semiconductor element 5 were mounted on the substrate 7 (see Fig. 3A, 3B), the number of prepared packages was 18.

Verification of warping:

Warping quantity of the semiconductor packages prepared in the above was verified in the following manner. That is, length of the maximum warping part from the horizontal surface when each semiconductor package was put on the horizontal surface was measured. An optical microscope was used in the measurement. In this connection, when the warping quantity is 50 μm or less, it is generally judged good.

PCT test:

Each of the semiconductor packages prepared in the above was put into a PCT chamber and allowed to stand for 196 hours under a condition of 130°C x 85% RH. Using this, the presence or absence of surface peeling in the semiconductor package was verified by a supersonic detector, and the number of packages which generated surface peeling was counted. In this connection, the number of prepared packages was 18 similar to the above.

Table 11

| | Examples | | | | | | | |
|---|---|---|---|---|---|---|---|---|
| | 17 | 18 | 19 | 20 | 21 | 22 | 23 | 24 |
| Filling property of semiconductor element and substrate (packages/18 packages) | 0/18 | 0/18 | 0/18 | 0/18 | 0/18 | 0/18 | 0/18 | 0/18 |
| Surface peeling of semiconductor element and encapsulating resin layer by PCT (packages/18 packages) | 0/18 | 0/18 | 0/18 | 0/18 | 0/18 | 0/18 | 0/18 | 0/18 |

(continued)

| | Examples | | | | | | | |
|---|---|---|---|---|---|---|---|---|
| | 17 | 18 | 19 | 20 | 21 | 22 | 23 | 24 |
| Warping quantity (μm) | 20 | 30 | 10 | 30 | 40 | 20 | 0 | 50 |

Table 12

| | Examples | | | | | | | |
|---|---|---|---|---|---|---|---|---|
| | 25 | 26 | 27 | 28 | 29 | 30 | 31 | 32 |
| Filling property of semiconductor element and substrate (packages/18 packages) | 0/18 | 0/18 | 0/18 | 0/18 | 0/18 | 0/18 | 0/18 | 0/18 |
| Surface peeling of semiconductor element and encapsulating resin layer by PCT (packages/18 packages) | 0/18 | 0/18 | 0/18 | 0/18 | 0/18 | 0/18 | 0/18 | 0/18 |
| Warping quantity (μm) | 20 | 35 | 15 | 25 | 35 | 15 | -5 | 50 |

Table 13

| | Competitive Examples | | | | | | | |
|---|---|---|---|---|---|---|---|---|
| | 10 | 11 | 12 | 13 | 14 | 15 | 16 | 17 |
| Filling property of semiconductor element and substrate (packages/18 packages) | 0/18 | 2/18 | 2/18 | 15/18 | 14/18 | 17/18 | 0/18 | 0/18 |
| Surface peeling of semiconductor element and encapsulating resin layer by PCT (packages/18 packages) | 0/18 | 0/18 | 0/18 | 0/18 | 0/18 | 0/18 | 4/18 | 6/18 |
| Warping quantity (μm) | 20 | 35 | 15 | 25 | 30 | 20 | 60 | 90 |

Table 14

| | Competitive Examples | | | | | |
|---|---|---|---|---|---|---|
| | 18 | 19 | 20 | 21 | 22 | 23 |
| Filling property of semiconductor element and substrate (packages/ 18 packages) | 3/18 | 2/18 | 3/18 | 3/18 | 3/18 | 2/18 |
| Surface peeling of semiconductor element and encapsulating resin layer by PCT (packages/18 packages) | 0/18 | 0/18 | 0/18 | 0/18 | 0/18 | 0/18 |
| Warping quantity (μm) | 20 | 30 | 40 | 25 | 25 | 35 |

Based on the above results, the products of Examples were excellent in filling property in the gap between the semiconductor element and substrate and showed no surface peeling, and the warping quantity was 50 μm or less in all cases. In addition, since excellent results were also obtained by the PCT test, it can be seen that a semiconductor device having superior excess moisture resistance reliability was obtained.

Contrary to this, un-filled part were confirmed in the products of Comparative Examples 10 to 12 because of the use of surface-untreated spherical molten silica. Unfilled part were frequently found in the products of Comparative Examples 13 to 15 because of the use of surface-treated minute spherical molten silica containing a large amount, namely 3.0% by weight, of the residue on sieve of 45 μm or more in particle diameter. Also, since the specified epoxy resin was not used in the products of Comparative Examples 16 and 17, they were excellent in filling property, but surface peeling of the semiconductor element and encapsulating resin layer was confirmed, and what is more, the warping quantity was large. In addition, un-filled parts were found in the products of Comparative Examples 18 to 20 due to large

particle diameter, and unfilled parts were also found in the products of Comparative Examples 21 to 23 because of the use of a surface treating agent which is not the agent of the invention.

## Claims

1. An epoxy resin composition for semiconductor encapsulation, which comprises the following component (A), component (B), component (C) and component (D):

    (A) an epoxy resin,
    (B) a phenol resin,
    (C) a curing accelerator, and
    (D) a spherical inorganic filler having been surface-treated with a silane coupling agent having acrylate group or methacrylate group,

    wherein the component (D) spherical inorganic filler has a containing ratio of 0.3% by weight or less for the one having a particle diameter of 45μm or more and has an average particle diameter of 15 μm or less.

2. The epoxy resin composition for semiconductor encapsulation described in claim 1, wherein in the component (D) spherical inorganic filler, a spherical inorganic filler having an average particle diameter of from 0.5 to 3 μm is contained within a range of from 5 to 50% by weight based on the entire inorganic filler.

3. The epoxy resin composition for semiconductor encapsulation described in claim 1, wherein the component (A) epoxy resin is an epoxy resin represented by the following general Formula (1)

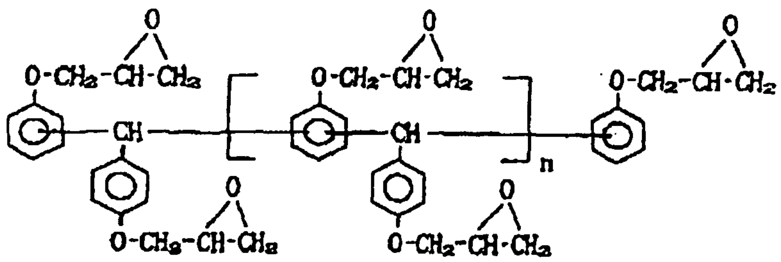

... (1)

    in the Formula (1), n is 0 or a positive number.

4. A semiconductor device which comprises the epoxy resin composition for semiconductor encapsulation described in claim 1 and a semiconductor element, wherein said semiconductor element is encapsulated with said epoxy resin composition.

## Patentansprüche

1. Epoxyharzzusammensetzung zur Einkapselung von Halbleitern, welche die folgende Komponente (A), Komponente (B), Komponente (C) und Komponente (D) umfasst:

    (A) ein Epoxyharz,
    (B) ein Phenolharz,
    (C) einen Härtungsbeschleuniger, und
    (D) einen kugelförmigen anorganischen Füllstoff, der mit einem Silan-Haftvermittler, der eine Acrylatgruppe oder Methacrylatgruppe aufweist, oberflächenbehandelt worden ist,

    wobei der kugelförmige anorganische Füllstoff der Komponente (D) einen Anteil von 0,3 Gew.-% oder weniger des Füllstoffs mit einem Teilchendurchmesser von 45 μm oder mehr enthält und einen mittleren Teilchendurchmesser von 15 μm oder weniger aufweist.

2. Epoxyharzzusammensetzung zur Einkapselung von Halbleitern nach Anspruch 1, wobei in dem kugelförmigen anorganischen Füllstoff der Komponente (D) ein kugelförmiger anorganischer Füllstoff mit einem mittleren Teilchendurchmesser von 0,5 bis 3 μm in einem Bereich von 5 bis 50 Gew.%, bezogen auf den gesamten anorganischen Füllstoff, enthalten ist.

3. Epoxyharzzusammensetzung zur Einkapselung von Halbleitern nach Anspruch 1, wobei das Epoxyharz der Komponente (A) ein Epoxyharz ist, das durch die folgende allgemeine Formel (1) wiedergegeben ist

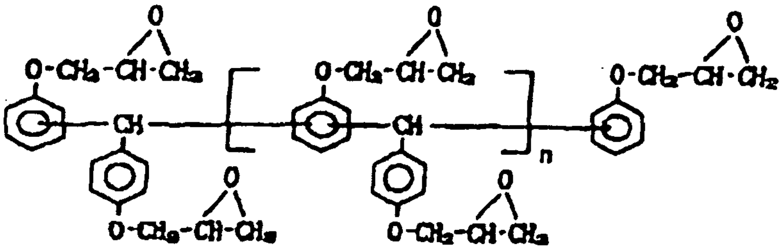

··· (1)

wobei in der Formel (1) n 0 oder eine positive Zahl ist.

4. Halbleitervorrichtung, welche die Epoxyharzzusammensetzung zur Einkapselung von Halbleitern nach Anspruch 1 und ein Halbleiterelement umfasst, wobei das Halbleiterelement mit der Epoxyharzzusammensetzung eingekapselt ist.

**Revendications**

1. Composition de résine époxyde pour l'encapsulation de semi-conducteurs, qui comprend le composant (A), le composant (B), le composant (C) et le composant (D) suivants :

(A) une résine époxyde,
(B) une résine phénolique,
(C) un accélérateur de durcissement, et
(D) une charge inorganique sphérique ayant été traitée en surface avec un agent de couplage silane ayant un groupe acrylate ou un groupe méthacrylate,

où le composant (D) charge inorganique sphérique a une proportion de contenu de 0,3 % en poids ou moins pour celle ayant un diamètre de particule de 45 μm ou plus et a un diamètre de particule moyen de 15 μm ou moins.

2. Composition de résine époxyde pour l'encapsulation de semi-conducteurs décrite dans la revendication 1, où dans le composant (D) charge inorganique sphérique, une charge inorganique sphérique ayant un diamètre de particule moyen de 0,5 à 3 μm est contenue dans une plage de 5 à 50 % en poids sur la base de la charge inorganique entière.

3. Composition de résine époxyde pour l'encapsulation de semi-conducteurs décrite dans la revendication 1, où le composant (A) résine époxyde est une résine époxyde représentée par la formule générale (1) suivante

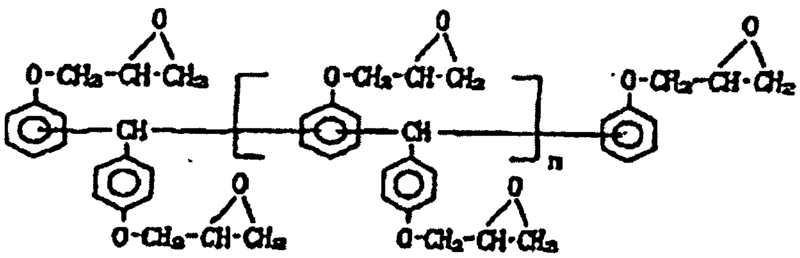

··· (1)

dans la formule (1), n est 0 ou un nombre positif.

4. Dispositif semi-conducteur qui comprend la composition de résine époxyde pour l'encapsulation de semi-conducteurs décrite dans la revendication 1 et un élément semi-conducteur, où ledit élément semi-conducteur est encapsulé avec ladite composition de résine époxyde.

FIG. 1A

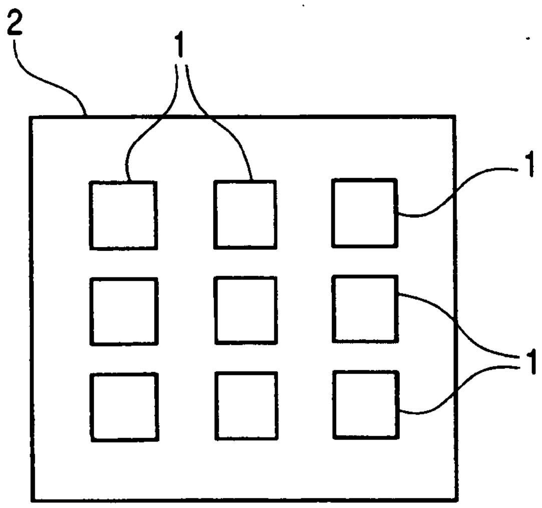


FIG. 1B

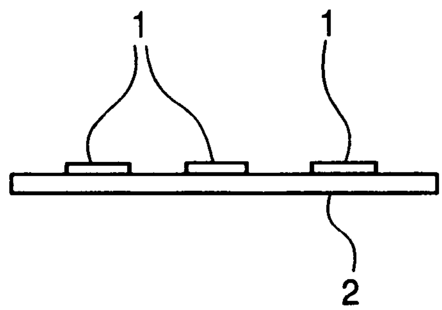


FIG. 2

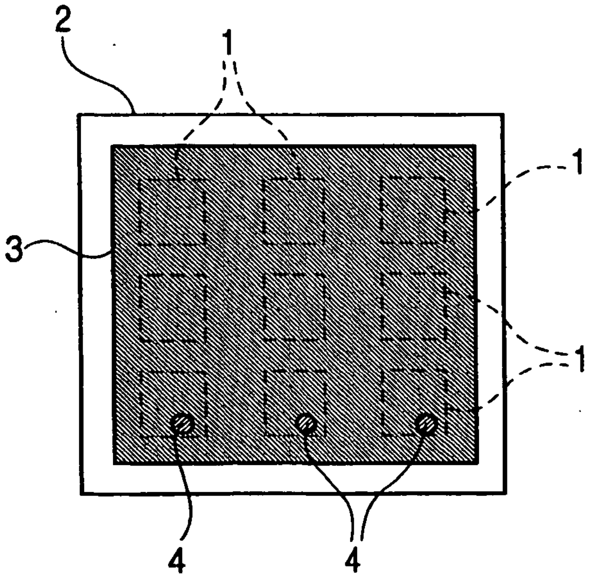

FIG. 3A

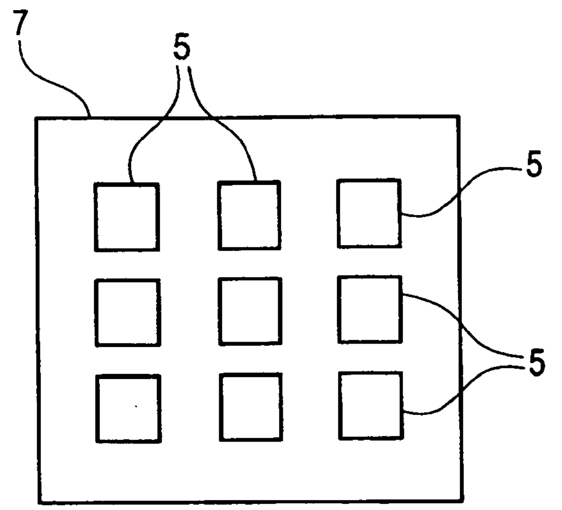


FIG. 3B

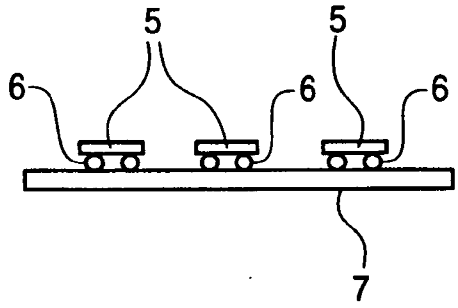


FIG. 4

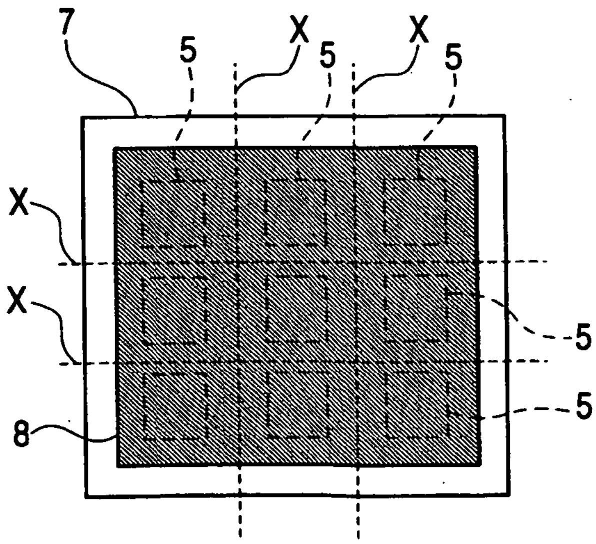

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8111468 A
- JP 2000281878 A
- JP 4078433 A
- JP 08311310 A
- EP 0285450 A